# EUROPEAN PATENT APPLICATION

(11) **EP 2 312 661 A1**
(43) Date of publication of application: **20.04.2011**
(21) Application number: 09360046.8
(22) Date of filing: 16.10.2009
(51) Int. Cl.: H01L 35/30, H01L 23/38

(54) **Thermoelectric assembly**

(71) Applicant: Alcatel Lucent, 75008 Paris (FR)
(72) Inventor: Kim, Kyoung Joon, Dunboyne (IE)
(74) Representative: Leppard, Andrew John

(57) **Abstract**

A thermoelectric module and assembly are disclosed. The assembly comprises a thermally superconductive structure operable to couple with a heat-generating component; a thermoelectric generator coupled with the thermally superconductive structure and operable to generate electrical power in response heat from the heat-generating component; a common heat sink coupled with the thermoelectric generator and operable to dissipate heat; and a heat shunt coupled with the thermally superconductive structure and the common heat sink, the heat shunt being operable to provide a first thermal path between the thermally superconductive structure and the common heat sink. The heat shunt provides additional flow paths from heat source to the common heat sink to reduce the net thermal resistance of the system. This enables both power to be generated by converting the waste heat of the components into electricity and the temperature of the heat-generating components to be effectively controlled. The particular arrangement of the thermally superconductive structure, the heat shunt and the common heat sink helps to maximise the amount of power generated for any particular desired heat-generating component operating temperature. The provision of a common heat sink coupled with the thermoelectric generator and the heat shunt maximises heat flow through the thermoelectric generator. Because the thermoelectric generator is being operated with both optimised efficiency and heat flow, this maximises the power generated under any particular operating conditions.

## Description

### FIELD OF THE INVENTION

The present invention relates to a thermoelectric assembly.

### BACKGROUND

Thermoelectric assemblies incorporating thermoelectric modules (TEMs) are a class of semiconductor-based devices that may be used to, for example, heat or cool an object, or may be used to generate power when placed in contact with a hot object. Generally, TEMs comprise two plates between which semiconductor pellets of alternating doping type are arranged in series electrically, and in parallel thermally. As current flows through the pellets, one side of the TEM becomes colder and the other warmer. Conversely, when placed in a thermal gradient, the TEM may drive a current through a load. TEMs have been used to cool a device, or to maintain an operating temperature of the device with the aid of a feedback loop.

Although TEMs provide beneficial properties, undesirable consequences can occur when utilising TEMs in practical implementations. Accordingly, it is desired to provide an improved thermoelectric module.

### SUMMARY

According to a first aspect, there is provided a thermoelectric assembly, comprising: a thermally superconductive structure operable to couple with a heat-generating component; a thermoelectric generator coupled with the thermally superconductive structure and operable to generate electrical power in response heat from the heat-generating component; a common heat sink coupled with the thermoelectric generator and operable to dissipate heat; and a heat shunt coupled with the thermally superconductive structure and the common heat sink, the heat shunt being operable to provide a first thermal path between the thermally superconductive structure and the common heat sink.

The first aspect recognises that when utilising a thermoelectric module to generate power, the thermoelectric module acts as a severe thermal insulator and thus the thermoelectric module increases the net thermal resistance of the system. This increase in thermal resistance results in a considerable increase in the temperature of the components to be cooled, which are being used as the heat source. This increase in component temperature is often detrimental to the reliability and the performance of the components. For example, when the component is an electronic component, the junction temperature can increase to a detrimental level. Accordingly, the heat shunt provides additional flow paths from heat source to the common heat sink to reduce the net thermal resistance of the system. This enables both power to be generated by converting the waste heat of the components into electricity and the temperature of the heat-generating components to be effectively controlled. Also, the particular arrangement of the thermally superconductive structure, the heat shunt and the common heat sink helps to maximise the amount of power generated for any particular desired heat-generating component operating temperature. This is because the thermally superconductive structure minimises any thermal gradient between the heat-generating component and the thermoelectric generator thus ensuring that the heated side of the thermoelectric generator gets as hot as possible. Hence, the thermoelectric generator can operate at its maximum possible efficiency for the desired operating temperature of the heat-generating component. Also, the provision of a common heat sink coupled with the thermoelectric generator and the heat shunt maximises heat flow through the thermoelectric generator. Because the thermoelectric generator is being operated with both optimised efficiency and heat flow, this maximises the power generated under any particular operating conditions. Also, the provision of the heat shunt provides an alternate thermal path to the common heat sink to prevent over heating of the heat-generating component.

In one embodiment, the common heat sink is coupled with the thermoelectric generator via a portion of the heat shunt, the portion of the heat shunt providing a second thermal path between the common heat sink and the thermoelectric generator. Accordingly, the heat shunt may provide an additional thermal path between the thermoelectric generator and the common heat sink. It will be appreciated that the provision of the heat shunt between the thermoelectric generator and the common heat sink may help improve heat transfer between the thermoelectric generator and the common heat sink thus further helping to operate the thermoelectric generator as efficiently as possible by cooling the non-heated side.

In one embodiment, the heat shunt contacts with the thermoelectric generator, the common heat sink and the thermally superconductive structure. Accordingly, the heat shunt may contact and provide heat paths between all three components. It will be appreciated that the contact may be either directly between the structures or via thermal pastes to optimise heat flow. Hence, the heat shunt may provide additional thermal paths between these components to help enable the thermal electric generator to generate the most amount of power possible.

In one embodiment, the thermoelectric generator, the heat shunt and the heat sink form a thermal resistance network in which the common heat sink is provided in series with a parallel arrangement of the thermoelectric generator and the heat shunt. The particular arrangement of the common heat sink in series with the parallel arrangement of the thermoelectric generator and the heat shunt helps to maximise the heat flow through the thermo electric generator. It will be appreciated that maximising the heat flow through the thermo electric generator helps to maximise the amount of power generated. For example, when utilising such a resistance network in combination with the thermally superconductive structure, the power produced by the thermoelectric generator may be an order of magnitude greater than arrangement in which a first heat sink is provided coupled with the thermoelectric generator and a separate heat sink is provided coupled by a conventional heat spreader with the heat generating device. This is because the heat spreader introduces a thermal resistance and so the thermoelectric generator in that arrangement will not be operating at its most efficient. Also, the provision of separate heat sinks provides a completely parallel thermal resistance network which reduces the flow through the thermo electric generator. These two combined sub-optimised characteristics significantly reduce the amount of power otherwise producible by the thermoelectric generator.

In one embodiment, the heat shunt extends from the thermally superconductive structure to the common heat sink, around at least a portion of the thermoelectric generator. Accordingly, the thermoelectric generator may be provided sandwiched between the thermally superconductive structure and the common heat sink. The heat shunt may be provided around the thermoelectric generator, between the thermal super conductive structure and the common heat sink, around at least a portion of the periphery of the thermoelectric generator. This arrangement may enable the additional thermal path to be provided whilst also providing for mechanical support and increasing the mechanical integrity of the structure.

In one embodiment, the thermoelectric assembly comprises a plurality of the thermoelectric generators and the heat shunt extends from the thermally superconductive structure to the common heat sink, around at least a portion of each of the plurality of thermoelectric generators. Accordingly, when more than one thermoelectric generator is provided, the heat shunt may be provided around portions of the edges of those thermoelectric generators to provide the additional heat path and also to help improve the mechanical integrity of the structure.

In one embodiment, the heat shunt contacts with the thermally superconductive structure at at least one of a central region and a peripheral region of the thermally superconductive structure. Accordingly, the heat shunt may extend between the heat sink and the thermally superconductive structure around the periphery of the thermally superconductive structure and/or regions within the thermally superconductive structure between thermoelectric generators to help improve heat flow and the mechanical integrity of the structure.

In one embodiment, a thermal resistance of the thermally superconductive structure is substantially zero. Accordingly, the conductivity of the superconductive structure is extremely high to maximise heat flow from the heat-generating component. This helps to provide an isothermal structure between the heat-generating component and the thermoelectric generator. This isothermal structure helps improve the energy conversion efficiency of the thermoelectric generator. This is because the temperature of the hot side of the thermoelectric generator is almost identical to that of the heat-generating component and the structure increases the isothermal footprint which increases heat flow through the thermoelectric generator and generates more electricity.

In one embodiment, the thermoelectric generator is operable to generate the electrical power in response to the temperature difference between two surfaces of the thermoelectric generator and the thermally superconductive structure is operable to transfer heat from the heat-generating component to cause one of the two surfaces to be substantially equal to a junction temperature of the heat-generating component. Accordingly, the temperature at the hot side of the thermoelectric generator will be substantially equal to that of the heat-generating component, which helps to maximise the efficiency of the thermoelectric generator.

In one embodiment, the thermally superconductive structure comprises a vapour chamber. It will be appreciated that the heat transfer provided by a vapour chamber provides a very high effective thermal conductivity that is typically two orders of magnitude greater than that of, for example a conventional heat spreader made of copper.

In one embodiment, the thermoelectric generator comprises alternately doped semiconductor pellets arranged to be in series electrically and in parallel thermally. According to a second aspect of the present invention there is provided an electrical module comprising: a heat-generating component; and a thermoelectric assembly of the first aspect.

Further particular and preferred aspects of the present invention are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

Embodiments of the present invention will now be described further, with reference to the accompanying drawings, in which:
Figure 1 illustrates an arrangement of a vapour chamber;
Figure 2 illustrates an arrangement of a thermoelectric generator;
Figure 3 illustrates an arrangement of a thermoelectric assembly according to one embodiment;
Figure 4 illustrates an arrangement of a thermoelectric assembly according to one embodiment; and
Figure 5 is a schematic diagram illustrating the arrangement of Figures 3 and 4 as an equivalent thermal resistance network.

### DESCRIPTION OF THE EMBODIMENTS

In overview, embodiments provide a vapour chamber integrated thermo-electric energy scavenger assembly that generates electricity using waste heat from components such as power amplifiers, CPU chips, or other high heat-flux components such as may be found in automobiles. To enable a thermoelectric generator to generate power from the waste heat, whilst preventing the temperature of the components from increasing above an acceptable operating temperature, shunt heat spreaders are provided which provide additional heat flow paths from the heat sources, and optionally from the thermoelectric generator, to a common heat sink and thus reduce the net thermal resistance of the assembly. This additional thermal path helps to regulate the temperature of the components and to control the heat flow to the thermoelectric generator, as will be described in more detail below.

Before discussing the assembly in detail, an explanation will first be given of some of the main components of the assembly.

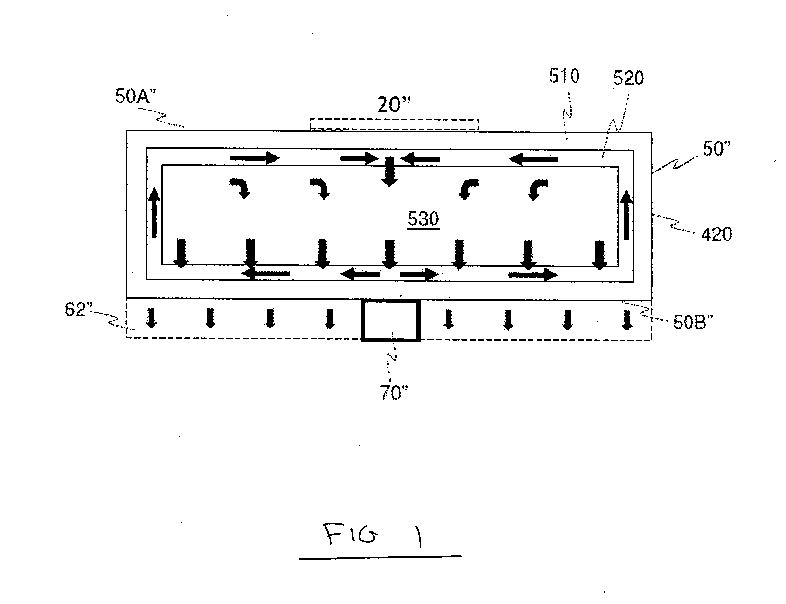

Figure 1 illustrates a vapour chamber 50", which is an example of a thermally superconductive structure which transports heat from a device 20" to a thermoelectric generator 62" and a heat shunt 70". The structure of this vapour chamber 50" is similar to those discussed below. A wall 510 defines an interior volume of the vapour chamber 50" comprising a wick 520 and a chamber 530. The wick 520 is wetted with a working fluid such as alcohol or water. The wall 510 provides structural support to the vapour chamber 50" (sometimes in addition to internal structural supports, not shown), and has sufficient thermal conductivity to ensure that the vapour chamber 50" has a low thermal resistance between the major surfaces 50A", 50B". The thermal conductivity of the wall 510 is high enough that heat is effectively conducted between the device 20" and the wick 520, and between the wick 520 and the thermoelectric generator 62". The wall 510 also provides some lateral spreading before heat is conducted into the wick 520, which typically has a much lower thermal conductivity. The wall 510 may be formed from materials having a thermal conductivity of about 200 W/m-K or higher, such as, e.g., copper or aluminium. A commercially available example of such a vapour chamber 50" is the Therma-Base™ vapour spreader manufactured by Thermacore International Co., Lancaster PA.

The wall 510 is lined at least partially with the wick 520. The wick 520 may be, for example, a porous metal such as sintered copper, metal foam or screen, or an organic fibrous material. If the thermoelectric generator 62" is configured to collect thermal energy from the device 20", the working fluid evaporates from the wick 520 to a vapour in the chamber 530 and carries energy from the vicinity of the device 20" by virtue of the heat of vaporization associated with the phase change. The vapour diffuses through the chamber 530 and condenses at a liquid-vapour interface on the wick 520 proximate the second major surface 50B", thereby transferring the heat of condensation of the working fluid to the larger area of the second major surface 50B". The condensed working fluid then cycles in the wick 520 to the region proximate the device 20" by capillary action.

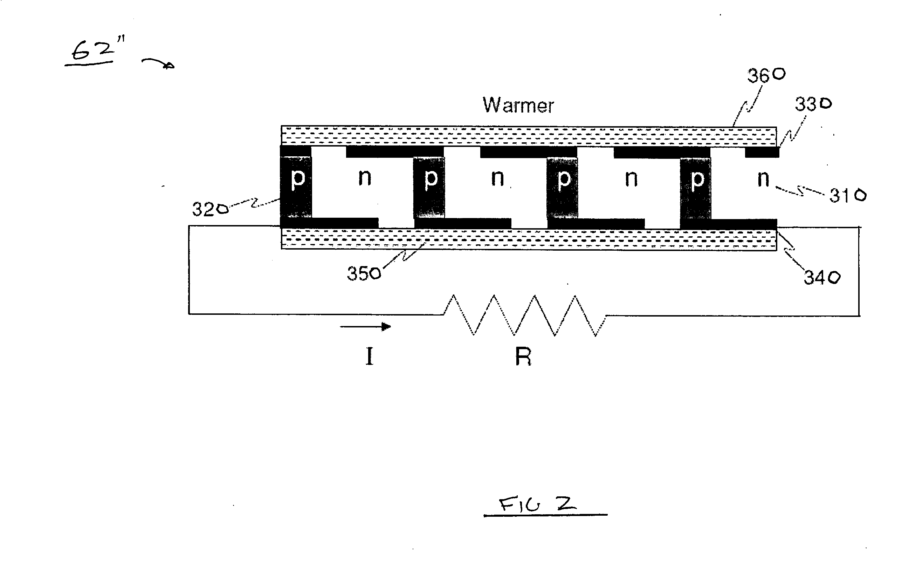

Figure 2 illustrates an arrangement of a thermoelectric generator 62". The structure of this thermoelectric generator 62" is similar to those discussed below. The thermoelectric generator 62" includes n-doped pellets 310 and p-doped pellets 320. The pellets 310, 320 are connected by a first set of electrodes 330 and a second set of electrodes 340. The pellets 310, 320 and electrodes 330, 340 are configured to be electrically in series and thermally in parallel. A lower substrate 350 and an upper substrate 360 serve to electrically isolate the thermoelectric generator 62" from an object with which the thermoelectric generator 62" is placed in thermal contact, and to provide mechanical strength. The substrates 350, 360 may be formed from an electrically insulating ceramic with a sufficiently high thermal conductivity, such as, e.g., alumina (Al203), aluminium nitride (AIN) and beryllia (BeO).

The efficiency of heat transfer by the thermoelectric generator 62" decreases with increasing heat flux across the pellets 310, 320. The greater uniformity and lateral extent of heat transfer by the vapour chamber provides the ability to scale up the size of the heat spreader to limit the heat flux through the pellets 310, 320 to a value associated with increased efficiency. Because the vapour chamber provides much lower spreading resistance, the heat spreader can be made much larger to achieve the desired flux than can be done using a conventional heat spreader.

When the top side of the thermoelectric generator 62" configured as shown is made warmer than the bottom side, the thermoelectric generator 62" develops a voltage potential that may drive a current with the direction shown. The current can be used to drive a resistive load R to perform work directly or after conversion to a desired voltage.

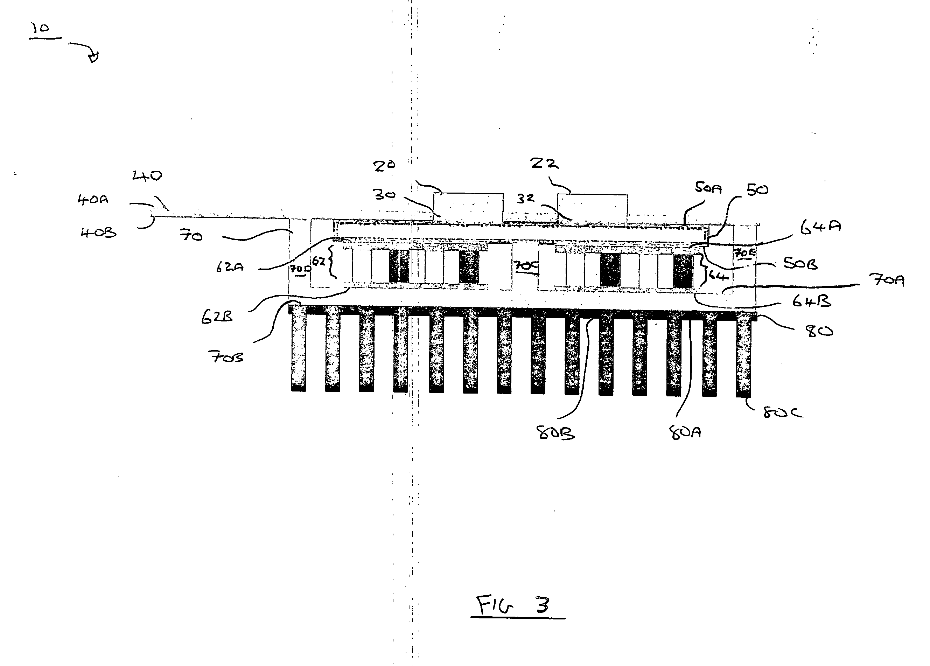

Figure 3 illustrates an arrangement of a thermoelectric assembly , generally 10, according to one embodiment. In this arrangement, the heat sources are electronic components 20, 22 provided on a printed circuit board 40. For example, the components 20,22 may be power amplifier transistors used in a base station or high power microprocessors. However, it will be appreciated that any other electrical or non-electrical heat source may be utilised. For example, the components 20, 22 may be high heat flux components from an automotive or other heat-generating component. In this arrangement, the electronic components 20, 22 are each mounted on a copper heat spreader 30, 32 provided within the circuit board 40. The electronic components 20, 22 are provided on a first major surface 40A of the printed circuit board 40. The copper heat spreader 30, 32 extend through the printed circuit board 40 from the first major surface 40A to a second major surface 40B of the printed circuit board 40. Although this arrangement shows two heat sources, it will be appreciated that any number of such heat sources may be provided.

In contact with the second major surface 40B of the printed circuit board 40 and the copper heat spreader 30, 32 is a vapour chamber 50. The vapour chamber 50 contacts with the second major surface 40B of the printed circuit board 40 and the copper heat spreader 30, 32 using a first major surface 50A. Accordingly, a thermal path is created between the electronic components 20, 22 and the vapour chamber 50 through the agency of the copper heat spreader 30, 32. Due to the near infinite thermal conductivity of the vapour chamber 50, the second major surface 50B of the vapour chamber achieves isothermality with the electronic components 20, 22. That is to say that the temperature at the second major surface 50B of the vapour chamber 50 is substantially the same as the operating or junction temperature of the electronic components 20, 22. It will be appreciated that the contact between the electronic components 20, 22, the copper heat spreader 30, 32 and the vapour chamber 50 may either be direct or via a thermal conduction paste operable to increase the efficiency of the thermal contact between these devices. Also, it will be appreciate that the copper heat spreader 30, 32 may be omitted and the components 20,22 may instead contact the vapour chamber 50.

A first major surface 62A, 64A of thermoelectric generators 62, 64 contacts with the second major surface 50B of the vapour chamber 50. Again, this contact may be either direct or via a thermal paste. Accordingly, the temperature of the first major surface 62A, 64A (i.e. the hot surface) of the thermoelectric generators 62, 64 will become substantially equal to that of the electronic components 20, 22.

Also contacting with the second major surface 50B of the vapour chamber 50 is a shunt heat spreader 70. The shunt heat spreader 70 has a first major surface 70A which contacts with the second major surface 62B, 64B of the thermoelectric generators 62, 64.

A rib 70C or other protrusion upstands from the first major surface 70A of the shunt heat spreader 70 and contacts with the second major surface 50B of the vapour chamber 50. In this particular arrangement, the rib 70C upstands between the thermoelectric generators 62, 64 in a region between the electronic components 20, 22. Also upstanding from the shunt heat spreader 70 are a pair of walls 70D, 70E which contact with and support the second major surface 40b of the printed circuit board 40. It will be appreciated that the walls 70D, 70E may extend around the periphery of the shunt heat spreader 70. Also, it will be appreciated that the combination of the walls 70D, 70E and the rib 70C may extend around the periphery of the thermoelectric generators 62, 64. The arrangement of the walls 70D, 70E and the rib 70C assist in improving the mechanical integrity of the device and prevent flexing of the assembly.

Coupled with a second major surface 70B of the shunt heat spreader 70 is a common or unitary heat sink 80. A first major surface 80A of the heat sink 80 contacts with the second major surface 70B of the shunt heat spreader 70. The heat sink 80 is provided with a plurality of rib-like structures 80C which extend from a second major surface 80B of the heat sink 80. The common heat sink 80 is used to dissipate heat to the ambient air by forced or natural convection.

Accordingly, it can be seen that two main heat-flow paths are provided for each component 20, 22. One major heat-flow path is from the electrical component 20 through the copper heat spreader 30, into the vapour chamber 50, through the thermoelectric generator 62, into the region of the shunt heat spreader 70 contacting the thermoelectric generator 62 and into the common heat sink 80. The second major heat-flow path is from the electronic components 20, through the copper heat spreader 30, into the vapour chamber 50, through the rib 70C of the shunt heat spreader 70 and into the common heat sink 80. A mirror set of thermal paths exist for electronic component 22.

This arrangement enables the hot side 62A, 64A of the thermoelectric generator 62, 64 to be as close to the operating temperature of the electronic components 20, 22 as possible, thereby enabling the thermoelectric generator 62, 64 to function as efficiently as possible. This arrangement also enables the cold side 62B, 64B of the thermoelectric generator 62, 64 to be cooled by the common heat sink 80, also enabling the thermoelectric generator 62, 64 to function as efficiently as possible. This enables power to be recovered and transferred over power lines (not shown) for other purposes. Also, the provision of the shunt heat spreader 70 helps to compensate for the high thermal resistance of the thermoelectric generator 62, 64. The provision of the common heat sink 80 in series with the thermoelectric generators 62, 64 and the shunt heat spreader 70 helps to decrease the thermal resistance of the thermal network thereby increasing the heat-flow through the thermoelectric generators 62, 64 to further help increase electrical power output from these.

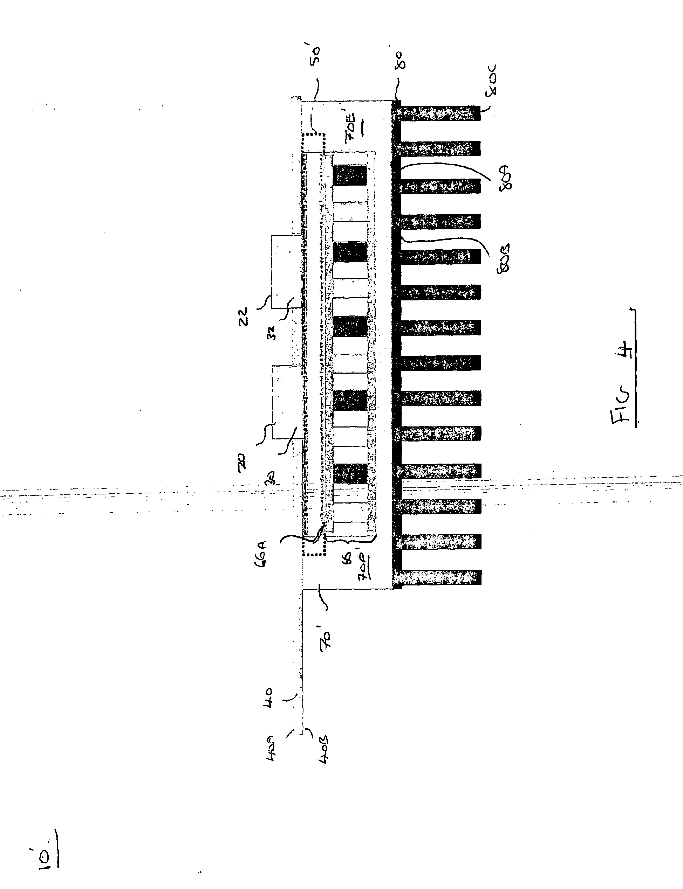

Figure 4 illustrates an arrangement of an electrical module 10' incorporating a thermoelectric assembly according to one embodiment. This embodiment is arranged identically to that shown in Figure 3, except for the arrangement of the vapour chamber 50', the thermoelectric generator 66 and the shunt heat spreader 70. In particular, a larger vapour chamber 50' and a larger thermoelectric generator 66 is used. The thermoelectric generator 66 extends across the entire region below the electronic components 20, 22. Accordingly, no rib 70c is provided in the shunt heat spreader 70' in the region between the electronic components 20, 22. Instead, the sidewalls 70D' and 70E' are slightly thicker and extend to and contact with the periphery of the vapour chamber 50'. These sidewalls 70D', 70E' provide a thermal path from the electronic components 20, 22 via the vapour chamber 50' and the shunt heat spreader 70' to the heat sink 80.

Accordingly, it can be seen once again that two main heat-flow paths are provided for each component 20, 22. One major heat-flow path is from the electrical component 20 through the copper heat spreader 30, into the vapour chamber 50', through the thermoelectric generator 66, into the region of the shunt heat spreader 70 contacting - the thermoelectric generator 66 and into the common heat sink 80. The second major heat-flow path is from the electronic components 20, through the copper heat spreader 30, into the vapour chamber 50, through the rib sidewall 70D of the shunt heat spreader 70' and into the common heat sink 80. A mirror set of thermal paths exist for electronic component 22.

This arrangement enables the hot side 66A of the thermoelectric generator 66 to be as close to the operating temperature of the electronic components 20, 22 as possible, thereby enabling the thermoelectric generator 66 to function as efficiently as possible. This arrangement also enables the cold side 66B of the thermoelectric generator 66 to be cooled by the common heat sink 80, also enabling the thermoelectric generator 66 to function as efficiently as possible. This enables power to be recovered and transferred over power lines (not shown) for other purposes. Also, the provision of the shunt heat spreader 70' helps to compensate for the high thermal resistance of the thermoelectric generator 66. The provision of the common heat sink 80 in series with the thermoelectric generator 66 and the shunt heat spreader 70' helps to decrease the thermal resistance of the thermal network thereby increasing the heat-flow through the thermoelectric generator 66 to further help increase electrical power output.

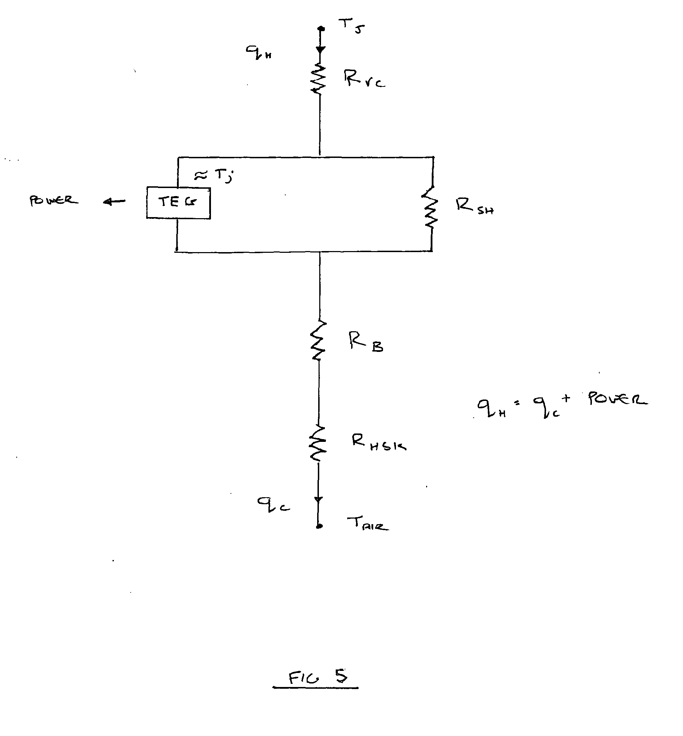

Figure 5 is a schematic diagram illustrating the arrangement of Figures 3 and 4 as an equivalent thermal resistance network. As can be seen, the thermal resistance of the vapour chamber 50, 50' is represented as Rvc; this is substantially zero. The thermal resistance of the shunt heat spreader 70,70' is represented as R_{SH}. The thermal resistance of the thermoelectric generator 62, 64, 66 is represented as TEG. The thermal resistance of the common heat sink 80 is represented as R_{HSK}. The thermal resistance of the thermal paste between the shunt heat spreader 70,70' and the common heat sink 80 is represented as R_{B}. The temperature of the device 20, 22 is T_{J}. The temperature of the ambient air surrounding the common heat sink 80 is T_{AIR}. The heat flow into the thermal resistance network is q_{H}, and the heat flow out of the common heat sink 80 is qc. Due to the electrical power generated by the thermoelectric generator 62, 64, 66, q_{H} = qc + power generated. As can be seen, the temperature of the warmer side of the thermoelectric generator 62, 64, 66 is substantially identical to T_{J}, due to the effect of the vapour chamber 50, 50'.

Hence, it can be seen that an arrangement is provided in which a Vapour Chamber Integrated Thermoelectric Energy Scavenger (VCITES) generates electricity using waste heat from electronic components such as power amplifier transistors, CPU chips, etc. The shunt heat spreaders provide additional heat flow paths from heat sources (electronic components) to the VCITES and thus reduce the net thermal resistance of the system. This enables power to be generated by converting the waste heat of electronic components into the electricity and controls the temperatures of electronic components. The working fluid in the wicks of the vapour chamber near the heat sources (electronic components) evaporates by absorbing the heat dissipated from the electronic components. The vapour is condensed in the lower side wicks and the condensed liquid transmits via the wicks to the hot side of the wicks due to the capillary pressure. The significant heat transfer due to the evaporation allows the vapour chamber to have a very high effective thermal conductivity that is typically two orders of magnitude greater than that of copper. The vapour chamber operates as a thermally superconductive plate and thus maintains the isothermality of the hot side of the thermoelectric module. The vapour chamber -absorbed heat conducts to the thermoelectric module and then the heat energy is converted into the electrical energy due to the Seebeck effect. The isothermality of the thermoelectric module hot side improves the energy conversion efficiency of the thermoelectric module. The greater effective footprint of the thermoelectric pellets and the more heat flow through thermoelectric module pellets will generate more electricity. However, the thermoelectric module is a thermal insulator due to the poor thermal conductivity of thermoelectric materials; and thus the thermoelectric module considerably increases the net thermal resistance of the thermoelectric module-vapour chamber assembly. The increased thermal resistance deteriorates the thermal performance of the electronic components. Hence, the shunt heat spreader controls the heat flow from the components to the thermoelectric module to maintain the junction temperatures of the components lower than the maximum temperatures that the reliability allows. The shunt heat spreader provides the additional thermal path from the electronic components to the heat sinks. The heat sinks are used to dissipate the heat to the ambient air by forced or natural convection.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A thermoelectric assembly, comprising:
a thermally superconductive structure operable to couple with a heat-generating component;
a thermoelectric generator coupled with said thermally superconductive structure and operable to generate electrical power in response heat from said heat-generating component;
a common heat sink coupled with said thermoelectric generator and operable to dissipate heat; and
a heat shunt coupled with said thermally superconductive structure and said common heat sink, said heat shunt being operable to provide a first thermal path between said thermally superconductive structure and said common heat sink.

2. The thermoelectric assembly of claim 1, wherein said common heat sink is coupled with said thermoelectric generator via a portion of said heat shunt, said portion of said heat shunt providing a second thermal path between said common heat sink and said thermoelectric generator.

3. The thermoelectric assembly of claim 1 or 2, wherein said heat shunt contacts with said thermoelectric generator, said common heat sink and said thermally superconductive structure.

4. The thermoelectric assembly of any preceding claim, wherein said thermoelectric generator, said heat shunt and said heat sink form a thermal resistance network in which said common heat sink is provided in series with a parallel arrangement of said thermoelectric generator and said heat shunt.

5. The thermoelectric assembly of any preceding claim, wherein said heat shunt extends from said thermally superconductive structure to said common heat sink, around at least a portion of said thermoelectric generator.

6. The thermoelectric assembly of any preceding claim, comprising a plurality of said thermoelectric generators and wherein said heat shunt extends from said thermally superconductive structure to said common heat sink, around at least a portion of each of said plurality of thermoelectric generators.

7. The thermoelectric assembly of any preceding claim, wherein said heat shunt contacts with said thermally superconductive structure at at least one of a central region and a peripheral region of said thermally superconductive structure.

8. The thermoelectric assembly of preceding claim, wherein a thermal resistance of said thermally superconductive structure is substantially zero.

9. The thermoelectric assembly of any preceding claim, wherein said thermoelectric generator is operable to generate said electrical power in response to said temperature difference between two surfaces of said thermoelectric generator and said thermally superconductive structure is operable to transfer heat from said heat-generating component to cause one of said two surfaces to be substantially equal to a junction temperature of said heat-generating component.

10. The thermoelectric assembly of any preceding claim, wherein said thermally superconductive structure comprises a vapour chamber.

11. The thermoelectric assembly of any preceding claim, wherein said thermoelectric generator comprises alternately doped semiconductor pellets arranged to be in series electrically and in parallel thermally.

12. An electrical module comprising:
a heat-generating component; and
a thermoelectric assembly as claimed in any preceding claim.
